Europäisches Patentamt

(19) European Patent Office

Office européen des brevets

(11) Publication number: **0 308 400 B1**

(12) **EUROPEAN PATENT SPECIFICATION**

(45) Date of publication of patent specification:
17.07.91 Bulletin 91/29

(51) Int. Cl.⁵ : **G03F 7/20**, G03F 7/26

(21) Application number: 87902126.9

(22) Date of filing: 27.03.87

(86) International application number:
PCT/GB87/00213

(87) International publication number:
WO 88/07705 06.10.88 Gazette 88/22

(54) **PROCESSING OF EXPOSED LITHOGRAPHIC PRINTING PLATES.**

The file contains technical information
submitted after the application was filed and
not included in this specification

(43) Date of publication of application:
29.03.89 Bulletin 89/13

(45) Publication of the grant of the patent:
17.07.91 Bulletin 91/29

(84) Designated Contracting States:
AT BE CH DE FR GB IT LI LU NL SE

(56) References cited:
EP-A- 0 103 337
DE-A- 3 137 430
GB-A- 2 171 530
US-A- 3 264 104
US-A- 3 723 120
US-A- 4 148 934
Research Disclosure, no. 262, February 1986
(New York, US), page 79, disclosure no. 26214
"Image reversal of positive photoresist with-
out additives"
Chemical Abstracts, vol. 91, no. 4, 23 July 1979
(Columbus, Ohio, US), page 674, abstract no.
30613y, & SU-A-652524

(73) Proprietor: HORSELL GRAPHIC INDUSTRIES
LIMITED
Howley Park Estate Morley
Leeds LS27 0QT (GB)

(72) Inventor: GARTH, Peter
Horsell Graphic Industries Limited
Howley Park Estate Leeds LS27 0QT (GB)
Inventor: SIMPSON, Stuart, M.
Horsell Graphic Industries Limited
Howley Park Estate Leeds LS27 0QT (GB)
Inventor: PARKINSON, John, E.
Horsell Graphic Industries Limited
Howley Park Estate Leeds LS27 0QT (GB)
Inventor: ROGERS, Alan, H.
Horsell Graphic Industries Limited
Howley Park Estate Leeds LS27 0QT (GB)

(74) Representative: Orr, William McLean
URQUHART-DYKES & LORD 5th Floor, Tower
House Merrion Way
Leeds West Yorkshire, LS2 8PA (GB)

## Description

The invention relates to the processing of exposed lithographic printing plates.

It is known that lithographic printing plates having certain light sensitive coatings, such as that comprising an orthoquinone diazide described in our British Patent 2082339, may be reversed during processing whereby a negative of an original image may be produced on the plates by the successive steps of imagewise exposing the plates, heating them to convert the coating in the irradiated areas to a form insoluble in alkaline developer and then overall exposing the plates whereby the coating in the areas not previously irradiated are decomposed to a form soluble in such developer. The conversion on irradiation at least of the coating of the specific example is understood to be a degradative process resulting in the formation of carboxyl groups.

It is desirable from an economic standpoint that the reversal process be carried out at high speed and preferably by passing the plates through the steps of heating and overall exposing in an integrated processing machine, but whilst the thermal conversion of the coating on the imagewise exposed areas of the plates may readily be effected at high speed, difficulty has been experienced in completing the reversal process at the same speed of throughput.

It is also known from US-A-3,264,104 to provide a process for achieving a negative from positive image by a two-stage exposure procedure, but this involves an intermediate development of the resist-exposed plate with either an aqueous alkali solution or hot (80 to 100°C and preferably boiling) water. Furthermore, this reference specifically teaches that if, following this water development, the plate does not dry by evaporation of its own accord, a special drying process can be employed prior to the subsequent blanket exposure.

Accordingly, the teachings in this reference specifically describe a process in which water is used in an intermediate development process, prior to a second exposure step of a dry plate.

It is further known from Research Disclosure No 262, February 1986 (New York) US to provide a process which involves a unique set of processing conditions to obtain a negative resist from a positive resist without the use of resist additives. However, it is quite clear from the teachings in this document that very special conditions are required, which are unique to this process.

In particular, the process refers to specific relative humidities of atmospheres during two irradiation steps, but makes no reference to a specifically water-enriched environment for the second irradiation step. The second irradiation step takes place under conditions of relative humidity which are comparable with those found in a normal working environment, and is therefore not a water-enriched environment, and this humidity is only a higher relative humidity than that obtaining in the environment in which the first irradiation step takes place, which is carried out under artificially dry conditions i.e. at approximately 1% relative humidity.

Accordingly, the Research Disclosure document does not teach the carrying out of a second irradiation step in a water enriched environment.

The present invention therefore seeks to provide a method and apparatus for the reversal processing of lithographic printing plates having an improved irradiation stage.

According to one aspect the invention provides a method for the reversal processing of a lithographic printing plate having a light sensitive coating at one surface and comprising the steps of :

imagewise exposing a portion of the coated surface to render the portion soluble in developer ;

heating the plate to render the imagewise exposed portion relatively insoluble in the developer;

carrying out overall irradiation of the coated surface, after heating of the plate, to solubilise the remaining portion of the coated surface not previously exposed : and,

developing the plate by dissolving the remaining portion of the coated surface :

characterised in that the irradiation is applied to the coated surface of the plate through a water-rich environment surrounding the plate.

In one preferred arrangement, the water-rich environment is provided by means of a chamber provided with water sprays which form a high humidity surrounding atmosphere.

In a further preferred arrangement, the water-rich environment is provided by application of water to the coated surface of the plate. Conveniently, this may be achieved by passing the plate through a water bath.

Advantageously, a cooling step is carried out between the heating step and the irradiation step.

The light sensitive coating provided on the lithographic printing plate is preferably an aromatic quinone diazide, and optionally with a resol or Novolak resin.

According to a further aspect the invention provides apparatus for use in the reversal processing of a lithographic printing plate having a light sensitive coating at one surface, a portion of which surface having been imagewise exposed to actinic radiation to render the portion soluble in developer, and the apparatus comprising :

means for heating the plate to render the imagewise exposed portion relatively insoluble in the developer ; and,

means for applying overall irradiation to the coated surface, after heating of the plate, to solubilise the remaining portion of the coated surface not previously exposed so that the remaining portion can be removed during subsequent development;

characterised by an enclosure through which the plate is passed to receive the irradiation and which enclosure is arranged to define a water-rich environment surrounding the plate and on which irradiation means is mounted to apply irradiation to the plate through the water-rich environment.

In a preferred embodiment, the enclosure is formed by a water bath, and conveying means may be provided to convey a succession of plates through the heating means and the water bath.

First and second nip rollers may be arranged to introduce the plates into the water bath and to pull the plates out of the bath after treatment.

A cooler device may be arranged between the heating means and the water bath.

The irradiation may be carried out using a UV lamp.

Embodiments of the invention will now be described by way of example and with reference to the accompanying schematic drawings of which:

Fig. 1 shows an embodiment of a plate processing machine in longitudinal section;

Fig. 2 shows a further embodiment in similar section.

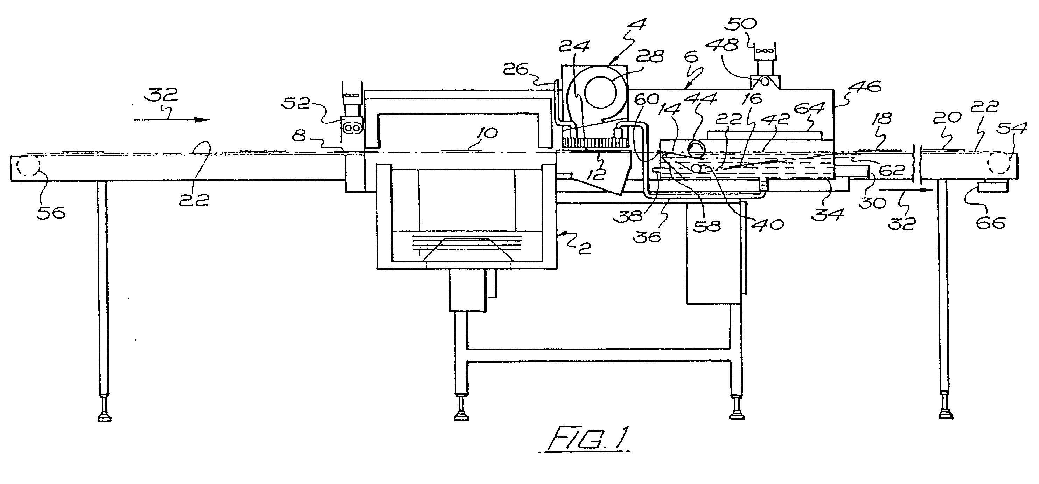

As shown in Fig. 1, the lithographic processing unit comprises an oven 2, a cooling unit 4 and an irradiating unit 6 through each of which plates 8-20 are passed continuously, with their sensitised surfaces uppermost and supported in conventional fashion on a plurality of endless chains 22 spaced laterally of the units so as to support the plates across their full width. The chains are pulled through the processing unit in the direction of arrow 32 by sprocket 54 at a speed in the range 1 m/min or faster and restrained by flanged pulleys 56 so that the upper, plate-supporting reach is taut and the lower, return, reach (not shown) is slack.

Plate 8 is shown entering the oven 2 and plate 10 is shown within the oven which, is set at a temperature to heat the plates to between, say, 120°-140°C. At high throughput speeds, the conventional oven may not provide enough power to raise the temperature of the plates as required during the time the plates remain therein, and it may be necessary to augment the heating step with an infra-red pre-heater 52.

It is believed that heated plates need to be cooled to improve the operation of irradiation, and cooling unit 4 is arranged to reduce the temperature of the plates to below about 50°C. The cooling unit comprises a heat exchanger 24 fed with cold mains water through inlet pipe 26 and with ambient air forced through by impeller 28. Cooled are thus impinges on the plates as they pass through the cooler, exemplified by plate 12, and escapes into the irradiating unit 6.

Beyond the cooling unit in the direction of movement of the plates is a shallow bath 34 about 600 mm long and of width similar to that of the oven. Water is fed into the bath from the heat-exchanger by means of a tube 36 whilst excess water runs over a weir 58, of which the upper edge, determining the water level 42, is just below the chains 22, and is removed through outlet pipe 38.

The chains, passing over a polypropylene guide 60 at the entrance to the bath, are deflected sharply downwardly into the water by means of non-rotating transverse bar 40 from which they then incline gradually upwardly to pass out of the bath over a second polypropylene guide 62. Whilst the trailing edges of the plates, which are substantially rigid, are supported by the portion of the chains leading to the guide 60, the leading edges project forwardly over the surface of the water in the bath until they come in contact with a rotary brush roller 44, located above and forwardly of the downwardly inclined portion of the chains, which presses on the leading edges of those plates, such as plate 14 shown, and guides them to enter the water and re-engage with the chains as they rise towards the guide 62.

A housing 46 is arranged over the bath and encloses a single high-powered (5kw) UV lamp 48 arranged transversely of the direction of movement of the plates. The housing 46 is ventilated by air from the cooling unit which is then vented to atmosphere, by the aid of extractor fan 50. This also removes any ozone produced by lamp 48 which is a potential health hazard.

While the plates are located of the order of 30 mm below the level of the water in the bath, as plate 16 shown, they are irradiated with ultraviolet light from lamp 48 through a glass screen 64. The irradiation through the water is found to be more efficacious in the short time they are passing through the irradiation unit, than would be the case if the sensitive face of the plates were in contact with dry air.

Water draining from the chains 22 and a plate, such as plate 18 shown, on emergence from the bath over guide 62, is collected in drip tray 30, whilst a further drip tray 66 collects water which drains from the chains as they turn about the sprocket 54.

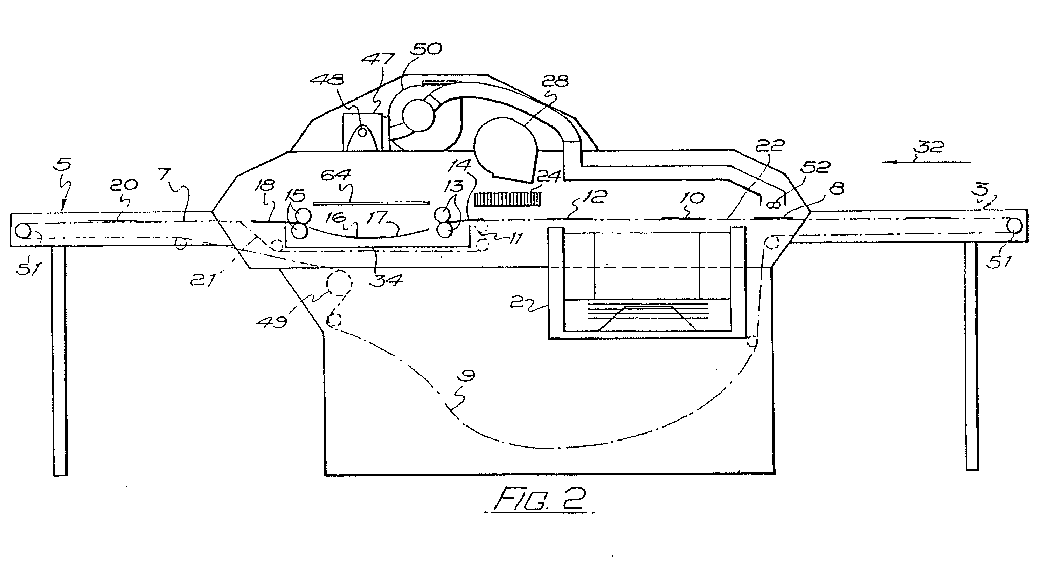

Fig. 2 shows a plate processing machine of a further embodiment, which may be of alternative width according to the size of plates to be processed.

In this embodiment, features which have counterpart in the Fig. 1 embodiment will generally be referred to by a similar reference and thus the processing machine comprises an oven 2 about 600 mm length located beneath the upper reach of a plurality of endless chains 22 upon which plates 8 to 20 are passed from an input station 3 to an output station 5. The chains are drawn through the machine by sprockets 49 below bath 34 and restrained by flanged pulleys 51 at both ends of the machine whereby the upper reach 7 is taut and the lower reach 9 is slack.

Downstream of the oven the plates such as plate 12 pass into a cooling zone wherein a fan 28 drives air onto the plates via a heat exchanger 24 which is fed with cold mains water.

On leaving the cooling zone, the chains 22 are deflected along a downward path 11, whereby the leading edge of successive plates, exemplified by plate 14, project over a rectangular water bath 34.

The bath 34, which is of width and length similar to that of the oven is supplied with water from the heat exchanger 24, which is maintained at a constant level by conventional means not shown.

A pair of transverse feed rollers 13 is arranged at the upstream end of the water bath 34 with the nip between them slightly below the water level, whilst a further pair of rollers 15 is arranged at the downstream end of the bath with its nip just out of the water. A perforated bed 17 of polypropylene is arranged within the bath extending transversely and, with a slight concave curvature lengthwise thereof between the roller pairs 13 and 15.

The rollers 13 are rotated so that their contiguous surfaces move forwardly at the same rate as the chains 22 so that they receive the leading edge of successive plates and introduce them into the water in the bath as the chains 22 are diverted downwardly without causing the trailing edge to slide over the chains. The upper roller of the pair 13 is positioned slightly forwardly of the other in the direction of movement of the plates so that as the plates emerge forwardly of the roller pair, and because by nature they are somewhat flexible, the plates are pushed at a slight downward angle into the water until they make contact with the bed 17. Still gripped by the roller pair 13 each successive plate is then guided by the bed 17 and eventually directed upwardly and ultimately out of the water to be received in the nip between the rollers 15 of which the upper one is slightly rearward of the lower.

The distance between the roller pairs 13 and 15 is such that the shortest plate intended to be processed on the machine will be gripped by roller pair 15 at its leading edge before the trailing edge leaves the nip of the roller pair 13. The rollers of the pair 15 are synchronised with the rollers 13 so that there is no slip between the plate and either pair of rollers in the event that a longer plate is held for a short time in both nips. The nip between the rollers 15 being above the level of water in the bath, the rollers exert a squeegee effect on the plates as they withdraw them from the bath.

The upper reach 7 of the array of chains 22, having been diverted downwardly over portion 11, is guided under the water bath 34 and inclined upwardly forwardly of the bath, over portion 21 so as to be in a position to receive the plates emerging from the nip of the rollers 15 and convey them forwardly, as shown at 18, towards the output station 5.

A UV lamp 48 is arranged transversely of the machine over the water bath 34, and a horizontal glass screen 64 is arranged between the lamp 48 and the bath 34. As described in connection with the first embodiment, a plate such as plate 16 shown is arranged to be irradiated overall by means of the lamp 48 while it is being passed under the water in the bath 34 whereby any portions of the coating of the plate not exposed to actinic radiation prior to heating in the oven 2 are now rendered alkali soluble by the action of radiation from the lamp 48.

The lamp 48 is enclosed within a housing 47 which is connected to an extractor fan 50 by which any ozone formed around the lamp 48 is withdrawn and vented to atmosphere. The extractor fan also serves to draw air from the vicinity of an infrared pre-heating element 52, located upstream of oven 2, and vent this to atmosphere.

While it is preferred that the water-rich environment surrounding the plates while they receive the irradiation is provided with a continuous layer of liquid water, it is within the scope of the invention to replace the water bath by a chamber in which a humidity greater than that of the surrounding atmosphere is established and maintained by means of an atomising spray or other suitable and conventional means.

## Claims

1. A method for the reversal processing of a lithographic printing plate having a light sensitive coating at one surface and comprising the steps of :
    imagewise exposing a portion of the coated surface to render the portion soluble in developer ;
    heating the plate to render the imagewise exposed portion relatively insoluble in the developer;
    carrying out overall irradiation of the coated surface, after heating of the plate, to solubilise the remaining portion of the coated surface not previously exposed ; and,
    developing the plate by dissolving the remaining portion of the coated surface :
    characterised in that the irradiation is applied to the coated surface of the plate through a water-rich environment surrounding the plate.

2. A method according to Claim 1, characterised in that the water-rich environment is provided by means of a chamber provided with water sprays which form a high humidity surrounding atmosphere.

3. A method according to Claim 1, characterised in that the water-rich environment is provided by application of water to the coated surface of the plate.

4. A method according to Claim 3, characterised in that the plate passes through a water bath.

5. A method according to any one of Claims 1 to 4, characterised by a cooling step carried out between the heating step and the irradiation step.

6. A method according to any one of Claims 1 to 5, characterised in that the light sensitive coating comprises an aromatic quinone diazide.

7. A method according to Claim 6, characterised in that the light sensitive coating further includes a resol or Novolak resin.

8. Apparatus for use in the reversal processing of a lithographic printing plate having a light sensitive coating at one surface, a portion of which surface having been imagewise exposed to actinic radiation to render the portion soluble in developer, and the apparatus comprising :

means (2) for heating the plate (8 to 20) to render the imagewise exposed portion relatively insoluble in the developer ; and,

means (48) for applying overall irradiation to the coated surface, after heating of the plate, to solubilise the remaining portion of the coated surface not previously exposed so that the remaining portion can be removed during subsequent development ;

characterised by an enclosure (34, 46) through which the plate is passed to receive the irradiation and which enclosure is arranged to define a water-rich environment surrounding the plate and on which irradiation means (48) is mounted to apply irradiation to the plate through the water-rich environment.

9. Apparatus according to Claim 8, characterised in that the enclosure is formed by a water bath (34).

10. Apparatus according to Claim 9, characterised by conveying means (22) for conveying a succession of plates (8 to 20) through the heating means (2) and the water bath (34).

11. Apparatus according to Claim 10, characterised by first nip rollers (13) arranged to introduce the plates into the water bath (34) and second nip rollers (15) arranged to pull the plates out of the water bath.

12. Apparatus according to any one of Claims 9 to 11, characterised by a cooler (4) arranged between the heating means (2) and the water bath (34).

**Patentansprüche**

1. Verfahren zur Umkehrbearbeitung einer Flachdruckplatte, die auf einer Oberfläche eine lichtempfindliche Beschichtung aufweist, umfassend die folgenden Verfahrensschritte :

Bildweises Belichten eines Teils der beschichteten Oberfläche, um den Teil in Entwickler lösbar zu machen ;

Aufheizen der Platte, um den bildweise belichteten Teil in dem Entwickler relativ unlöslich zu machen ;

Ausführen einer Gesamtstrahlung der beschichteten Oberfläche nach dem Aufheizen der Platte, um den verbleibenden Teil der beschichteten Oberfläche, der vorher nicht belichtet worden war, löslich zu machen ; und Entwickeln der Platte durch Auflösen des übrigen Teils der beschichteten Oberfläche ; dadurch **gekennzeichnet**, daß die Strahlung auf die beschichtete Oberfläche der Platte durch eine die Platte umgebende wasserreiche Umgebung aufgebracht wird.

2. Verfahren nach Anspruch 1, dadurch **gekennzeichnet**, daß die wasserreiche Umgebung durch eine Kammer geschaffen wird, die mit Wassersprays versehen ist, welche eine umgebende Atmosphäre hoher Feuchtigkeit bildet.

3. Verfahren nach Anspruch 1, dadurch **gekennzeichnet**, daß die wasserreiche Umgebung durch Aufbringen von Wasser auf die beschichtete Oberfläche der Platte geschaffen wird.

4. Verfahren nach Anspruch 3, dadurch **gekennzeichnet**, daß die Platte durch ein Wasserbad hindurchtritt.

5. Verfahren nach einem der Ansprüche 1 bis 4, **gekennzeichnet**, durch einen Kühlungsschritt, der zwischen dem Aufheizungsschritt und dem Bestrahlungsschritt ausgeführt wird.

6. Verfahren nach einem der Ansprüche 1 bis 5, dadurch **gekennzeichnet**, daß die lichtempfindliche Beschichtung ein aromatisches Chinondiazid umfaßt.

7. Verfahren nach Anspruch 6, dadurch **gekennzeichnet**, daß die lichtempfindliche Beschichtung ferner ein Resol- oder Novolakharz umfaßt.

8. Vorrichtung zur Verwendung bei der Umkehrbearbeitung einer Flachdruckplatte, welche eine lichtempfindliche Beschichtung auf einer Oberfläche besitzt, wobei ein Teil dieser Oberfläche bildweise einer aktinischen Strahlung ausgesetzt wurde, um den Teil in Entwickler lösbar zu machen, und wobei die Vorrichtung umfaßt :

Einrichtungen (2) zum Aufheizen der Platte (8 bis 20), um den bildweise belichteten Teil in dem Entwickler relativ unlöslich zu machen ; und

Einrichtungen (48) zur Anbringung einer Gesamtbestrahlung auf die beschichtete Oberfläche nach dem Aufheizen der Platte, um den verbleibenden Teil der beschichteten Oberfläche, der vorher nicht belichtet worden war, löslich zu machen, so daß der verbleibende Teil während der nachfolgenden Entwicklung entfernt werden kann ; **gekennzeichnet** durch eine Umhüllung (34, 46), durch welche die Platte zum Empfang der Strahlung geleitet wird und die derart angeordnet und ausgebildet ist, daß sie eine die Platte umgebende wasserreiche Umgebung begrenzt, und auf der Bestrahlungsmittel (48) montiert sind, um die Bestrahlung durch die wasserreiche Umgebung auf die Platte aufzubringen.

9. Vorrichtung nach Anspruch 8, dadurch **gekennzeichnet**, daß die Umhüllung durch ein Wasserbad (34) gebildet ist.

10. Vorrichtung nach Anspruch 9, **gekennzeichnet** durch Fördermittel (22) zur Förderung einer Folge von Platten (8 bis 20) durch Heizeinrichtung (2) und das Wasserbad (34).

11. Vorrichtung nach Anspruch 10, **gekennzeichnet** durch erste Klemmrollen (13), die zur Einführung der Platten in das Wasserbad (34) hinein angeordnet sind, und durch zweite Klemmrollen (15), die zum Herausziehen der Platten aus dem Wasserbad angeordnet und ausgebildet sind.

12. Vorrichtung nach einem der Ansprüche 9 bis 11, **gekennzeichnet** durch einen Kühler (4), der zwischen der Heizeinrichtung (2) und dem Wasserbad (34) angeordnet ist.

## Revendications

1. Procédé pour le traitement par inversion d'une plaque d'impression lithographique qui porte un revêtement photosensible sur une surface, ce développement comprenant les phases qui consistent à :
- exposer sous image une portion de la surface revêtue pour rendre cette portion soluble dans le révélateur ;
- chauffer la plaque pour rendre la portion exposée sous image relativement insoluble dans le révélateur ;
- effectuer une irradiation intégrale de la surface revêtue, après le chauffage de la plaque, pour rendre soluble la partie restante de la surface revêtue qui n'a pas été exposée précédemment ;
- développer la plaque en dissolvant la partie restante de la partie revêtue, caractérisé en ce que l'irradiation est appliquée à la surface revêtue de la plaque à travers un environnement riche en eau qui entoure la plaque.

2. Procédé selon la revendication 1, caractérisé en ce que l'environnement riche en eau est réalisé au moyen d'une chambre munie de pulvérisateurs d'eau qui forment une atmosphère environnante à taux d'humidité élevé.

3. Procédé selon la revendication 1, caractérisé en ce que l'environnement riche en eau est réalisé en déposant de l'eau sur la surface revêtue de la plaque.

4. Procédé selon la revendication 3, caractérisé en ce que la plaque passe à travers un bain d'eau.

5. Procédé selon l'une quelconque des revendications 1 à 4, caractérisé par une phase de refroidissement exécutée entre la phase de chauffage et la phase d'irradiation.

6. Procédé selon l'une quelconque des revendications 1 à 5, caractérisé en ce que le revêtement photosensible est constitué par un quinone diazide aromatique.

7. Procédé selon la revendication 6, caractérisé en ce que le revêtement photosensible comprend en outre une résine résol ou Novolak.

8. Machine destinée à être utilisée dans le traitement par inversion d'une plaque d'impression lithographique portant un revêtement photosensible sur une surface, une portion de cette surface ayant été exposée sous image à une radiation actinique pour rendre cette portion soluble dans le révélateur, et la machine comprenant :
- des moyens (2) servant à chauffer la plaque (8 à 20) pour rendre la portion exposée sous image relativement insoluble dans le révélateur ; et
- des moyens (48) servant à appliquer une irradiation intégrale à la surface revêtue, après le chauffage de la plaque, pour rendre soluble la portion restante de la surface revêtue qui n'a pas été exposée précédemment, de manière que la portion restante puisse être éliminée pendant le développement ultérieur, caractérisée par une enceinte (34, 36) à travers laquelle on fait passer la plaque pour qu'elle reçoive l'irradiation, laquelle enceinte est agencée pour définir un environnement riche en eau autour de la plaque, et sur laquelle des moyens d'irradiation sont montés pour appliquer l'irradiation (48) à la plaque à travers l'environnement riche en eau.

9. Machine selon la revendication 8, caractérisée en ce que l'enceinte est formée par un bain d'eau (34).

10. Machine selon la revendication 9, caractérisée par des moyens de transport (22) destinés à transporter une succession de plaques (8 à 20) à travers les moyens de chauffage (2) et le bain d'eau (34).

11. Machine selon la revendication 10, caractérisée par des premiers rouleaux de pincement (13) agencés pour introduire les plaques dans le bain d'eau (34) et des deuxièmes rouleaux de pincement (15) agencés pour tirer les plaques et les faire sortir du bain d'eau.

12. Machine selon une quelconque des revendications 9 à 11, caractérisée par un refroidisseur (4) agencé entre les moyens de chauffage (2) et le bain d'eau (34).

FIG.1.

7

_FIG. 2_

EP 0 308 400 B1